# EUROPÄISCHE PATENTANMELDUNG

(11) **EP 1 739 765 A1**
(43) Veröffentlichungstag der Anmeldung: **03.01.2007**
(21) Anmeldenummer: 05014318.9
(22) Anmeldetag: 01.07.2005
(51) Int. Cl.: H01L 51/56, H01L 51/52

(54) **Organische Leuchtdiode und Anordnung mit mehreren organischen Leuchtdioden**

(71) Anmelder: Novaled AG, 01307 Dresden (DE)
(72) Erfinder: Walzer, Karsten, 01099 Dresden (DE); Roch, Teja, 01309 Dresden (DE); Huang, Qiang, 01069 Dresden (DE); Leo, Karl, 01219 Dresden (DE)
(74) Vertreter: Bittner, Thomas L.

(57) **Zusammenfassung**

Die Erfindung bezieht sich auf eine organische Leuchtdiode sowie eine Anordnung mit mehreren organischen Leuchtdioden, wobei die organische Leuchtdiode eine Schichtanordnung mit einer Elektrode, einer Gegenelektrode und einer zwischen der Elektrode und der Gegenelektrode angeordneten organischen Schichtfolge aufweist. Die organische Schichtfolge ist auf einem Metallsubstrat angeordnet.

## Beschreibung

Die Erfindung liegt auf dem Gebiet elektrolumineszenter Lichtemissionseinrichtungen.

### Stand der Technik

Organische Leuchtdioden (OLED) sind seit der Demonstration niedriger Arbeitsspannungen von Tang et al. 1987 [C.W. Tang et al. Appl. Phys. Lett. 51 (12), 913 (1987)] aussichtsreiche Kandidaten für die Realisierung großflächiger Displays und Beleuchtungselemente. Sie bestehen aus einer Reihenfolge dünner (typischerweise 1nm bis 1µm) Schichten aus organischen Materialien, welche bevorzugt im Vakuum aufgedampft oder in ihrer polymeren Form aufgeschleudert werden. Nach elektrischer Kontaktierung mittels Metallschichten bilden sie vielfältige Bauelemente, wie Leuchtdioden, Displays und Beleuchtungskörper, die mit ihren Eigenschaften den etablierten Bauelementen auf der Basis anorganischer Schichten Konkurrenz machen.

Im Falle der organischen Leuchtdioden wird mittels Injektion von Ladungsträgern (Elektronen von der einen, Löcher von der anderen Seite) aus den Kontakten in die anschließenden organischen Schichten infolge einer äußeren angelegten Spannung, der folgenden Bildung von Exzitonen (Elektron-Loch-Paaren) in einer aktiven Zone und der strahlenden Rekombination dieser Exzitonen, Licht erzeugt und von der Leuchtdiode emittiert. Üblicherweise bestehen organische Leuchtdioden aus einer Folge mehrerer Schichten. Dies gilt insbesondere für im Vakuum durch Aufdampfen präparierte Bauelemente, bei denen die Funktionen Ladungsträgerinjektion aus den Elektroden, Ladungsträgertransport und Emission oft in verschiedenen Schichten stattfinden.

Der Vorteil solcher Bauelemente auf organischer Basis gegenüber den konventionellen Bauelementen auf anorganischer Basis (Halbleiter wie Silizium, Galliumarsenid) besteht darin, dass es möglich ist, sehr großflächige Elemente herzustellen, also große Anzeigeelemente (Bildschirme, Screens) oder Beleuchtungskörper. Die organischen Ausgangsmaterialien sind gegenüber den anorganischen Materialien relativ billig (geringer Material- und Energieaufwand). Obendrein können diese Materialien aufgrund ihrer gegenüber anorganischen Materialien geringen Prozeßtemperatur auf flexible oder frei formbare Substrate aufgebracht werden, was eine ganze Reihe von neuartigen Anwendungen in der Display- und Beleuchtungstechnik eröffnet.

Nach dem Stand der Technik werden organische Leuchtdioden meist auf Glassubstrate aufgebracht, die mit einer transparenten leitenden Oxidschicht (meist Indiumzinnoxid, ITO) beschichtet sind. Durch viele Anwendungen sind jedoch die Kosten dieses Substrats und der leitenden Schichten zu hoch: Zum einen verursacht das notwendige hochwertige Glas selbst hohe Kosten; zum anderen sind die elektrisch leitfähigen Oxide relativ teuer. Aus diesen Gründen wäre es sehr vorteilhaft, wenn man eine organische Leuchtdiode auf preisgünstigen Substraten realisieren könnte. Hierbei ist aber in der Regel die Problematik gegeben, dass die Leuchtdiode nach wie vor mit einem Kontakt versehen werden muss. Dies bedingt, dass man zunächst ein Substrat mit einer isolierenden Schicht versehen muss und anschließend wiederum eine Elektrodenschicht aufbringen muss, die als Grundelektrode für die organische Leuchtdiode dient. Ein weiterer Nachteil der üblichen organischen Leuchtdioden ist die meist gewählte Anordnung mit einem transparenten Substrat: Die Lichtemission der Leuchtdiode geschieht in diesem Fall durch die transparente Elektrode und das Substrat, während der gegenüberliegende Kontakt (meist die Kathode) lichtundurchlässig und im betreffenden Spektralbereich hoch reflektiv ist. Dadurch werden für die Anwendung ein hochtransparentes Substrat sowie transparente Kontaktschichten notwendig, die in vielen Fällen die Substratwahl stark einschränken und verhindern, dass besonders preisgünstige Substrate gewählt werden können.

Es wurden bereits Vorschläge für organische Leuchtdioden auf metallischen Substraten gemacht. Diese Substrate haben verschiedene Vorteile: Zum ersten sind metallische Substrate unter Umständen relativ preisgünstig herzustellen. Zum zweiten kann die hohe Wärmeleitung metallischer Substrate zu einem guten Abtransport der Abwärme beitragen. Zum dritten können metallische Substrate relativ dünn und dadurch flexibel gestaltet werden.

Im Dokument US 6,835,470 wird eine organische Leuchtdiode auf einer Metallfolie, bevorzugt Stahlfolie, vorgeschlagen. Die Leuchtdiode wird realisiert, indem auf das Substrat zunächst eine isolierende Schicht aufgebracht wird und anschließend eine leitfähige Elektrode. Die Anordnung in US6,835,470 sieht jedoch nur vor, dass das Metallsubstrat die negative Elektrode ist. Ein Ausführungsbeispiel für eine organische Leuchtdiode nach US6,835,470 wurde nicht angeführt.

### Die Erfindung

Aufgabe der Erfindung ist es, eine organische Leuchtdiode und eine Anordnung mit mehreren organischen Leuchtdioden mit einem vereinfachten Aufbau anzugeben.

Diese Aufgabe wird erfindungsgemäß durch eine organische Leuchtdiode nach den unabhängigen Ansprüchen 1 und 4 und eine Anordnung mit mehreren organischen Leuchtdioden nach den unabhängigen Ansprüchen 23 und 28 gelöst.

Die Erfindung umfasst den Gedanken, bei einer organischen Leuchtdiode mit einer Schichtanordnung, welche eine Elektrode, eine Gegenelektrode und eine zwischen der Elektrode und der Gegenelektrode angeordnete organische Schichtfolge umfasst, die organische Schichtfolge auf einem Metallsubstrat anzuordnen und die Schichtanordnung zwischen der organischen Schichtfolge und dem Metallsubstrat isolierschichtfrei auszubilden.

Ein weiterer Aspekt nutzt die Tatsache, dass durch den Einsatz dotierter Injektions- oder Transportschichten eine höhere Rauhigkeit des Substrates oder darauf abgeschiedener leitfähigher oder isolierender Schichten akzeptiert werden kann.

Nach einem weiteren Aspekt der Erfindung können mehrere derartige organische Leuchtdioden eine Anordnung bilden, bei der die mehreren organischen Leuchtdioden auf einzelnen elektrisch getrennten Bereichen des Metallsubstrats gebildet sind, indem das Metallsubstrat zur Ausbildung der elektrisch getrennten Bereiche teilweise mit einer isolierenden organischen Schicht versehen ist.

Mittels der Verwendung des Metallsubstrats ist ein vereinfachter Aufbau der organischen Leuchtdiode geschaffen, der insbesondere auch preisgünstig herstellbar ist, da anstelle der üblicherweise verwendeten Substratmaterialien ein kostengünstiges Metallsubstrat eingesetzt werden kann. Das Metallsubstrat kann auf einfache Art und Weise mit den Schichten der organischen Leuchtdiode beschichtet werden, beispielsweise in einem Rolle-zu-Rolle Verfahren.

Bei einer Ausgestaltung der Erfindung kann vorgesehen sein, dass die organische Schichtfolge eine oder mehrere Ladungsträger-Transportschichten mit einer Beimischung (Dotierung) zur Erhöhung der elektrischen Leitfähigkeit umfasst. Die Verwendung derartiger Beimischungen als solche ist bekannt (vgl. DE 100 58 578). Solche Schichten sind besonders vorteilhaft, da Metallsubstrate, insbesondere bei preisgünstiger Herstellungsweise, gewöhnlich durch eine hohe Rauhigkeit gekennzeichnet sind. Mittels Verwendung dotierter Transportschichten ist diese Rauhigkeit besser tolerierbar als in undotierten organischen Leuchtdioden, da zum einen die Ströme in undotierten organischen Leuchtdioden gewöhnlich durch Raumladungen begrenzt sind und deshalb kubisch von der Schichtdicke abhängen. In einer dotierten Transportschicht hingegen hängt der Strom linear von der Dicke ab, so dass Schichtdickenschwankungen durch ein rauhes Substrat sich deutlich weniger auswirken.

Zum zweiten ist es mit dotierten Transportschichten möglich, die Dicke der Transportschicht frei zu wählen und insbesondere ohne den Nachteil einer höheren Betriebsspannung auch dicker zu wählen. Dadurch wird wiederum die Gefahr von Kurzschlüssen durch metallische Nadeln auf dem Substrat reduziert. Weiterhin ist es mit diesen dickeren Transportschichten möglich, die optische Auskopplung der Leuchtdiode zu optimieren. Dies ist auf Metallsubstraten insbesondere wichtig, da die auf diesen Substraten hohe Reflexion dazu führt, dass die konstruktive Überlagerung der Lichtemission in beide Richtungen besonders wichtig wird. Bei einer dotierten Transportschicht wird es aufgrund der fast freien Wahl der Schichtdicke möglich, diese so zu wählen, dass sich für das in der organischen Schichtfolge erzeugte Licht besonders günstige konstruktive Interferenz ergibt, wobei oft auch noch die spektrale Lage des emittierten Lichtes optimiert werden kann. Beispielsweise wird bei den meisten organischen Leuchtdioden der Abstand der Emissionszone von der reflektierenden Elektrode so gewählt, dass sich eine konstruktive Interferenz ergibt, dies ist in der Regel der Fall, wenn der Abstand zur Elektrode etwa ein Viertel der Wellenlänge beträgt. Durch die Verwendung dotierter Transportschichten ist es möglich, eine höhere Ordnung der konstruktiven Interferenz zu wählen, z.B. drei Viertel der Wellenlänge, und dadurch die günstigen optischen Eigenschaften bei reduzierter Wahrscheinlichkeit von Kurzschlüssen durch das raue Substrat zu erhalten.

Zum dritten ist es durch die Verwendung dotierter Transportschichten möglich, das Material des Grundkontaktes relativ unabhängig von seiner Austrittsarbeit auszuwählen, was im Gegensatz zu OLEDs mit undotierten Transportschichten (die auf der Anodenseite eine möglichst hohe Austrittsarbeit des Substrates erfordern) die Möglichkeit eröffnet, das Substratmaterial nach Preis, optischen Eigenschaften und Prozessierbarkeit auszuwählen. Insbesondere wird es möglich, auch Metalle wie Aluminium oder Silber als Anode zu verwenden.

In einer bevorzugten Ausprägung können auch dotierte Transportschichten verwendet werden, die eine glättende Wirkung entfalten. Aufgrund des ohmschen Stromtransports in solchen Schichten wird die Gefahr von lokalen Strompfaden mit überhöhten Strömen, die zu Kurzschlüssen und zur Zerstörung des Bauelements führen können, reduziert.

Weitere bevorzugte Ausprägungen der Erfindung benutzen eine organische Leuchtdiode, bei der die optische Auskopplung mittels einer gezielten Aufrauhung oder Strukturierung des Substrats erhöht wird. Bei üblichen planaren Leuchtdioden besteht das Problem, dass wesentliche Teile der Lichtemission nicht in externe Moden gehen, sondern in Substratmoden oder Filmmoden der organischen Leuchtdiode. Mittels Verwendung von Metallsubstraten mit optischer Auskopplung vom Substrat weg (Top-Emitter) sind die Substratmoden bereits unterdrückt. Die Ausbreitung von Licht in einer Filmmode kann unterdrückt werden, indem das Substrat mit einer periodischen oder nichtperiodischen Rauhigkeit versehen wird. Dies ist insbesondere bei einer Rolle-zu-Rolle Fertigung sehr einfach möglich, da hier zum Beispiel eine direkte Formung des Substrats während des Walzprozesses mit einer Rolle möglich ist; in günstigen Fällen kann sogar die bei einem Walzprozess üblicherweise unbeabsichtigt entstehende Struktur vorteilhaft genutzt werden.

Eine besonders günstige Fertigungsmethode für die hier vorgeschlagenen Bauelemente stellt die Fertigung in einer Rolle-zu-Rolle Anlage dar. Hierbei werden die Substrate von einer Rolle abgerollt, im Vakuum werden nacheinander (z.B. aus linearen Quellen) die organischen Schichten und die Gegenelektrode aufgebracht, und anschließend wird nach dem Aufbringen weiterer Schichten zur Verkapselung, das fertige Produkt wieder auf einer Rolle aufgerollt.

Dabei ist es auch möglich, die notwendige Strukturierung mit einer isolierenden Schicht zur Erzielung abgegrenzter organischer Leuchtdioden in diesen Prozess zu integrieren, beispielsweise mittels Drucken polymerer isolierender Schichten, durch Abscheidung isolierender Schichten mit Hilfe lokalen Verdampfens oder Sputterns, oder durch Verdampfen oder Sputtern durch eine Schattenmaske.

Weiterhin ist es natürlich möglich, auf einer Metallfolie auch eine Anordnung von Bildpunkten zu realisieren, beispielsweise ein Passiv-Matrix-Display. Hier wird die untere Elektrode in Streifen eingeteilt; dazu senkrecht wird die obere Elektrode ebenfalls in Streifen aufgedampft. Mit dieser Anordnung könnten dann die einzelnen Bildpunkte angesteuert werden und eine wechselnde Bildinformation dargestellt werden.

Eine für die Erzeugung von spektral breitem oder weißem Licht besonders günstige Anordnung besteht auch darin, dass einzelne Segmente von Leuchtdioden mit verschiedenem Emissionsspektrum nebeneinander angeordnet werden. Dadurch ist es möglich, effizient spektral breitbandiges Licht zu erzeugen. Diese Anordnung kann in Streifen oder in anderen periodisch oder nichtperiodisch wiederholten Elementen geschehen. Um das Bauelement dem Betrachter möglichst homogen emittierend erscheinen zu lassen, ist es auch möglich, auf die Anordnung eine optisch streuende Schicht aufzubringen. Diese Schicht kann auf die Anordnung direkt abgeschieden werden oder auch durch Lamination oder Kleben angebracht werden. Eine besonders günstige Anordnung besteht darin, die zur Verkapselung notwendigen Schichten so auszulegen, dass sie gleichzeitig die Funktion der optischen Streuung übernehmen.

### Ausführungsbeispiele der Erfindung

Die Erfindung wird im folgenden anhand von Ausführungsbeispielen unter Bezugnahme auf Figuren einer Zeichnung näher erläutert. Hierbei zeigen:
- Fig. 1: eine Strom-Spannungskennlinie für organische licht-emittierende Bauelemente nach einer Ausführungsform der Erfindung; und
- Fig. 2: eine Leuchtdichte-Spannungskennlinie für organische lichtemittierende Bauelemente nach einer weiteren Ausführungsform der Erfindung.

Eine Ausführungsform für eine blau emittierende OLED umfasst die folgenden Schichten:
- 1: Substrat, Aluminiumfolie
- 2: Silberschicht, gesputtert
- 3: Löchertransportschicht: Spiro-TTB, p-dotiert mit 2% NDP-2, 35 nm dick
- 4: Elektronenblockschicht, Spiro-TAD, 10 nm
- 5: Emitterschicht - Blauer Emitter BH 120, 20 nm
- 6: Elektronentransportschicht, BPhen, 10 nm
- 7: Elektronentransportschicht, BPhen, n-dotiert mit Cs im Verhältnis 1:1, 130 nm
- 8: Transparente Kathode, Ag aufgedampft, 15 nm

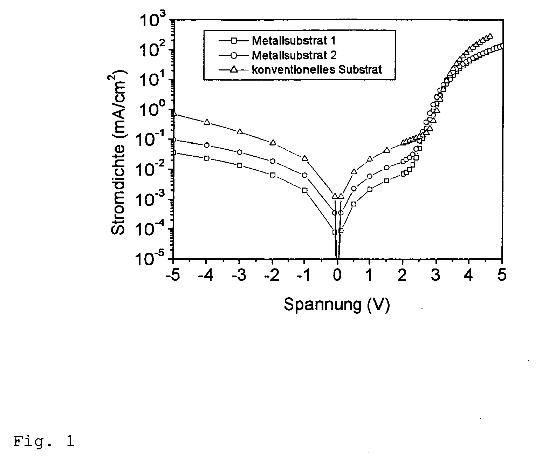

Fig. 1 zeigt eine Strom-Spannungskennlinie von zwei organischen lichtemittierenden Bauelementen dieser Art (Quadrate und Kreise); zum Vergleich dazu ist ein Bauelement (Dreiecke) gezeigt, das auf einem hochwertigen Glassubstrat mit einem unter Reinraumbedingungen gefertigten Cr/Ag-Kontakt realisiert wurde. Es ist offensichtlich, dass die OLEDs auf den Aluminiumfolien deutlich besser sperrende Kennlinien haben.

Eine weitere Ausführungsform für eine grün emittierende OLED umfasst die folgenden Schichten:
- 10: Substrat, Aluminiumfolie
- 11: Silberschicht, gesputtert
- 12: Löchertransportschicht: Spiro-TTB, p-dotiert mit 2% NDP-2, 48 nm dick
- 13: Elektronenblockschicht, Spiro-TAD, 10 nm
- 14: Emitterschicht I, TCTA: Ir(ppy)₃ (9%), 5 nm
- 15: Emitterschicht II, TPBI: Ir(ppy)₃ (9%), 10 nm
- 16: Elektronentransportschicht, BPhen, 10 nm
- 17: Elektronentransportschicht, BPhen, n-dotiert mit Cs im Verhältnis 1:1, 130 nm
- 18: Transparente Kathode, Ag aufgedampft, 15 nm
- 19: Deckschicht: Spiro-TTB, 90 nm

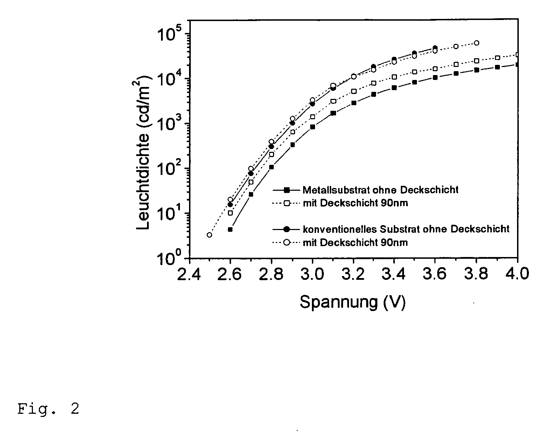

Fig. 2 zeigt eine Leuchtdichte-Spannungskennlinie von zwei organischen lichtemittierenden Bauelementen nach der weiteren Ausführungsform (Quadrate und Kreise, jeweils mit und ohne Schicht 19). Die Helligkeit von 100 Cd/m² wird bereits bei 2,9 V erreicht, die maximale Leistungseffizienz beträgt bei 10.000 Cd/m² 50 lm/W. Hierdurch ist gezeigt, dass auf metallischen Substraten OLEDs mit hervorragenden Parametern realisiert werden können.

Den genannten Ausführungsformen ist gemeinsam, dass zwischen dem Metallsubstrat und der untersten Schicht der organischen Schichtfolge keinerlei Isolierschicht gebildet ist. Alternativ zu den erläuterten Ausführungsformen kann vorgesehen sein, dass die organische Schichtfolge direkt auf das Metallsubstrat aufgebracht ist, so dass mit dem Metallsubstrat, beispielsweise der Aluminiumfolie, die untere Elektrode der organischen Leuchtdiode gebildet ist. Auf diese Weise wird das Material zum Ausbilden einer getrennt von dem Metallsubstrat hergestellten Elektrode eingespart. Auch ein hierfür notwendiger Verfahrensschritt bei der Herstellung der organischen Leuchtdiode kann eingespart werden.

Es kann jedoch auch vorteilhaft sein, das Substrat mit weiteren Schichten zu versehen. Dazu gehören beispielsweise dielektrische Schichten, die z.B. zu einer Erhöhung der Reflektion genutzt werden können, oder isolierende organische Zwischenschichten. Eine besonders vorteilhafte Anordnung ist z.B. eine dielektrische Schicht mit einer anschließenden dünnen Silberschicht als Elektrode. Eine solche Anordnung ist auch besonders vorteilhaft für die erwähnte Passivmatrix-Anordnung.

Die in der vorstehenden Beschreibung, den Ansprüchen und den Zeichnungen offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Organische Leuchtdiode mit einer Schichtanordnung, welche eine Elektrode, eine Gegenelektrode und eine zwischen der Elektrode und der Gegenelektrode angeordnete organische Schichtfolge umfasst, **dadurch gekennzeichnet, dass** die organische Schichtfolge auf einem Metallsubstrat angeordnet und die Schichtanordnung zwischen der Licht emittierenden organischen Schichtfolge und dem Metallsubstrat isolierschichtfrei gebildet ist.

2. Organische Leuchtdiode nach Anspruch 1, **dadurch gekennzeichnet, dass** die organische Schichtfolge direkt auf dem Metallsubstrat aufgebracht ist, so dass mit dem Metallsubstrat die Elektrode gebildet ist.

3. Organische Leuchtdiode nach Anspruch 1, **dadurch gekennzeichnet, dass** die Elektrode als Metallschicht auf dem Metallsubstrat gebildet ist.

4. Organische Leuchtdiode mit einer Schichtanordnung, welche eine Elektrode, eine Gegenelektrode und eine zwischen der Elektrode und der Gegenelektrode angeordnete organische Schichtfolge umfasst, **dadurch gekennzeichnet, dass** die organische Schichtfolge auf einem Metallsubstrat angeordnet und die der Elektrode zugewandte Transportschicht oder Folge von transportierenden und injizierende Schichten mit einer Beimischung zur Erhöhung der elektrischen Leitfähigkeit versehen ist.

5. Organische Leuchtdiode nach Ansprüchen 1 bis 4, **dadurch gekennzeichnet, dass** die Elektrode ein positiver elektrischer Kontakt und die Gegenelektrode ein negativer elektrischer Kontakt ist.

6. Organische Leuchtdiode nach Ansprüchen 1 bis 4, **dadurch gekennzeichnet, dass** die Elektrode der negative elektrische Kontakt und die Gegenelektrode der positive elektrische Kontakt ist.

7. Organische Leuchtdiode nach einem der Ansprüche 1 bis 6, **dadurch gekennzeichnet, dass** die als Elektrode gebildete Metallschicht wenigstens teilweise aus Silber ist.

8. Organische Leuchtdiode nach einem der vorangehenden Ansprüche, **dadurch gekennzeichnet, dass** das Metallsubstrat aus Aluminium besteht.

9. Organische Leuchtdiode nach einem der vorangehenden Ansprüche, **dadurch gekennzeichnet, dass** das Metallsubstrat aus Stahl besteht.

10. Organische Leuchtdiode nach einem der vorangehenden Ansprüche, **dadurch gekennzeichnet, dass** das Metallsubstrat flexibel ist.

11. Organische Leuchtdiode nach einem der vorangehenden Ansprüche, **dadurch gekennzeichnet, dass** die organische Schichtfolge eine oder mehrere Ladungsträger-Transportschichten mit einer Beimischung zur Erhöhung der elektrischen Leitfähigkeit umfasst.

12. Organische Leuchtdiode nach Anspruch 11, **dadurch gekennzeichnet, dass** eine dem Metallsubstrat zugewandte Ladungsträger-Transportschicht mit einer eine Lichtemission mittels konstruktiver Emission unterstützenden Schichtdicke gebildet ist.

13. Organische Leuchtdiode nach Anspruch 12, **dadurch gekennzeichnet, dass** die Schichtdicke der dem Metallsubstrat zugewandten Ladungsträger-Transportschicht ¾ λ oder größer ist, wobei λ die Emissionswellenlänge von Licht ist, welches von der Schichtanordnung emittiert wird.

14. Organische Leuchtdiode nach einem der vorangehenden Ansprüche, **dadurch gekennzeichnet, dass** eine dotierte Ladungstransportschicht verwendet wird, die eine glättende Wirkung hat.

15. Organische Leuchtdiode nach Ansprüchen 10 bis 13, **dadurch gekennzeichnet, dass** eine dotierte Transportschicht mit C₆₀ als Matrixmaterial verwendet wird.

16. Organische Leuchtdiode nach einem der vorangehenden Ansprüche, **dadurch gekennzeichnet, dass** das Metallsubstrat mit einer periodischen oder einer nicht periodischen Struktur versehen ist, die eine optische Auskopplung von in der organischen Schichtfolge erzeugtem Licht verbessert.

17. Organische Leuchtdiode nach einem der vorangehenden Ansprüche, **dadurch gekennzeichnet, dass** die Schichtanordnung auf einer abschließenden Elektrode ein transparentes Schichtsystem zum Schutz gegen Umwelteinflüsse aufweist.

18. Organische Leuchtdiode nach Anspruch 17, **dadurch gekennzeichnet, dass** die transparente Schicht auflaminiert ist.

19. Organische Leuchtdiode nach einem der vorangehenden Ansprüche, **dadurch gekennzeichnet, dass** die Schichtanordnung Weißlicht emittierend gebildet ist.

20. Organische Leuchtdiode nach einem der vorangehenden Ansprüche, **dadurch gekennzeichnet, dass** die emittierenden Schichten in lateral angeordneten Streifen oder anderen periodischen oder nichtperiodischen geometrischen Elementen mit verschiedenen Emittermaterialien angeordnet sind, wobei in der Überlagerung eine bestimmte spektrale Emission, beispielsweise Weißlicht, erzielt wird.

21. Organische Leuchtdiode nach Anspruch 20, **dadurch gekennzeichnet, dass** auf die organische Leuchtdiode eine optisch streuende Schicht aufgebracht ist, die zu einer Überlagerung der verschiedenen emittierten Spektren führt.

22. Organische Leuchtdiode nach einem der vorangehenden Ansprüche, **dadurch gekennzeichnet, dass** die Schichtanordnung Weißlicht emittierend gebildet ist, indem mehrere organische Leuchtdioden monolithisch übereinander gestapelt sind.

23. Anordnung mit mehreren organischen Leuchtdioden nach einem der Ansprüche 1 bis 22, **dadurch gekennzeichnet, dass** die mehreren organischen Leuchtdioden auf einzelnen elektrisch getrennten Bereichen des Metallsubstrats gebildet sind, indem das Metallsubstrat zum Ausbilden der elektrisch getrennten Bereiche teilweise mit einer isolierenden Schicht versehen ist.

24. Anordnung nach Anspruch 23, **dadurch gekennzeichnet, dass** die isolierende Schicht auf das Metallsubstrat aufgedruckt ist.

25. Anordnung nach Anspruch 23, **dadurch gekennzeichnet, dass** die isolierende Schicht auf das Metallsubstrat aufgedampft ist.

26. Anordnung organischer Leuchtdioden nach Anspruch 23, **dadurch gekennzeichnet, dass** die isolierende Schicht auf das Metallsubstrat aufgesputtert ist.

27. Anordnung organischer Leuchtdioden nach einem der Ansprüche 23 bis 26, **dadurch gekennzeichnet, dass** die dem Metallsubstrat zugewandte Elektrode mittels weiterer isolierender Schichten in Streifenelemente aufgeteilt ist und die von dem Metallsubstrat abgewandte Gegenelektrode in zu den Streifenelementen senkrecht gebildete weitere Streifenelemente unterteilt ist, so dass einzelne ansteuerbare Bildpunkte einer Passiv-Matrix-Anzeige gebildet sind.

28. Anordnung mit mehreren organischen Leuchtdioden nach einem der Ansprüche 1 bis 27, **dadurch gekennzeichnet, dass** die mehreren organischen Leuchtdioden auf einzelnen Bereichen des Metallsubstrats gebildet sind, indem die Gegenelektrode in lateral begrenzte Elemente unterteilt ist.

29. Organische Leuchtdiode nach einem der vorangehenden Ansprüche, **dadurch gekennzeichnet, dass** die Schichtanordnung kontinuierlich von Rolle-zu-Rolle gefertigt ist.

30. Organische Leuchtdiode nach Ansprüchen 20 bis 27, **dadurch gekennzeichnet, dass** die Schichtanordnung kontinuierlich auf einem Band von Rolle-zu-Rolle gefertigt ist und die Streifen dadurch erzielt werden, dass die Bedampfungsquellen quer zum Band räumlich getrennte Dampfkeulen emittieren.
